(19) Europäisches Patentamt
European Patent Office
Office européen des brevets

(11) EP 1 705 763 B1

(12) EUROPEAN PATENT SPECIFICATION

(45) Date of publication and mention
of the grant of the patent:
**01.10.2008 Bulletin 2008/40**

(51) Int Cl.:
*H01S 5/125* (2006.01)  *H01S 5/183* (2006.01)

(21) Application number: **06005297.4**

(22) Date of filing: **15.03.2006**

(54) **Quantum cascade laser with grating formed by a periodic variation in doping**

Quantenkaskaden-Laser mit durch periodische Dotierung geformtem Gitter

Laser à cascade quantique avec grille formée par dopage périodique

(84) Designated Contracting States:
**AT BE BG CH CY CZ DE DK EE ES FI FR GB GR HU IE IS IT LI LT LU LV MC NL PL PT RO SE SI SK TR**

(30) Priority: **24.03.2005 US 88299**

(43) Date of publication of application:
**27.09.2006 Bulletin 2006/39**

(73) Proprietor: **Avago Technologies Fiber IP (Singapore) Pte. Ltd.**
**Singapore 768923 (SG)**

(72) Inventors:
• **Corzine, Scott W.**
**Loveland, CO 80537-0599 (US)**
• **Bour, David P.**
**Loveland, CO 80537-0599 (US)**
• **Hofler, Gloria E.**
**Loveland, CO 80537-0599 (US)**

(74) Representative: **Dilg, Haeusler, Schindelmann Patentanwaltsgesellschaft mbH**
**Nußbaumstrasse 6**
**80336 München (DE)**

(56) References cited:
EP-A- 0 895 323    US-A- 5 547 898
US-B1- 6 301 281

• WU M C ET AL: "GAAS/GAALAS DISTRIBUTED BRAGG REFLECTOR LASER WITH A FOCUSED ION BEAM, LOW DOSE DOPANT IMPLANTED GRATING" APPLIED PHYSICS LETTERS, AIP, AMERICAN INSTITUTE OF PHYSICS, MELVILLE, NY, US, vol. 53, no. 4, 25 July 1988 (1988-07-25), pages 265-267, XP000020108 ISSN: 0003-6951

• PATENT ABSTRACTS OF JAPAN vol. 014, no. 268 (E-0939), 11 June 1990 (1990-06-11) -& JP 02 083992 A (NEC CORP), 26 March 1990 (1990-03-26)
• PATENT ABSTRACTS OF JAPAN vol. 009, no. 123 (E-317), 28 May 1985 (1985-05-28) -& JP 60 010688 A (FUJITSU KK), 19 January 1985 (1985-01-19)
• GLEW R W ET AL: "New DFB grating structure using dopant-induced refractive index step" JOURNAL OF CRYSTAL GROWTH, ELSEVIER, AMSTERDAM, NL, vol. 261, no. 2-3, 19 January 2004 (2004-01-19), pages 349-354, XP004484141 ISSN: 0022-0248
• PAKULSKI G ET AL: "THE DIFFUSED GRATING DISTRIBUTED FEEDBACK LASER" PROCEEDINGS OF THE EUROPEAN CONFERENCE ON OPTICAL COMMUNICATION (ECOC) MONTREUX, SEPT. 12 - 16, 1993. REGULAR PAPERS, ZURICH, SEV, CH, vol. VOL. 2 CONF. 19, 12 September 1993 (1993-09-12), pages 361-364, XP000492241
• JOYCE T B ET AL: "IN-SITU MONITORING OF CARBON DOPED GAAS AND OF PERIODIC CARBON DOPED GAAS/ALAS STRUCTURES GROWN BY CHEMICAL BEAM EPITAXY" JOURNAL OF CRYSTAL GROWTH, ELSEVIER, AMSTERDAM, NL, vol. 146, no. 1/4, January 1995 (1995-01), pages 394-398, XP000511872 ISSN: 0022-0248
• SUGIMOTO M ET AL: "VERY LOW THRESHOLD CURRENT DENSITY IN VERTICAL-CAVITY SURFACE-EMITTING LASER DIODES WITH PERIODICALLY DOPED DISTRIBUTED BRAGG REFLECTORS" ELECTRONICS LETTERS, IEE STEVENAGE, GB, vol. 28, no. 4, 13 February 1992 (1992-02-13), pages 385-387, XP000292299 ISSN: 0013-5194

**Description**

Background

Quantum cascade lasers (QCL) use electronic intersubband transitions for lasing action in semiconductor superlattices. For light to be either strongly emitted or absorbed by intersubband transitions, the electric field of the light is typically perpendicular to the epitaxial layers and transverse magnetic (TM) polarized light is predominantly absorbed or emitted by intersubband transitions in quantum wells.

Surface plasmons are TM polarized waves that propagate along a metal and semiconductor interface. The amplitude of surface plasmons decreases exponentially on both sides of the interface. Surface plasmons are very lossy and any coupling between the surface plasmon mode and the lasing mode is not desirable because this coupling creates an additional loss mechanism for the laser.

Plasmon-waveguide structures have been introduced for transverse-mode confinement in QCLs because of the impracticality of growing cladding layers sufficiently thick to contain the long evanescent tail of the transverse mode present at the longer emission wavelengths of intersubband semiconductor lasers such as QCLs. Plasmon-waveguide structures provide optical confinement by significant lowering of the refractive index of the cladding layers by the use of high doping to increase the refractive index contrast. When the doping level is sufficiently high, the plasma frequency of the semiconductor approaches the QCL emission frequency so that the optical character of the semiconductor becomes more metal-like with a complex refractive index, n + ik, a small real component, n, and a large imaginary component, k. Adjusting the doping and thickness of the plasmon-waveguide structures allows the modal loss and the overlap with the quantum cascade gain to be optimized.

The requirements for doping in the visible and near-infrared wavelengths for plasmon confinement are typically too high to be practicable. However, at the longer, mid and far infrared (IR) wavelengths typically associated with QCLs, doping levels on the order of about $10^{18}/cm^3$ are sufficient to reduce the refractive index of the cladding layers at the operational wavelength of the QCL to provide transverse-mode confinement.

US 6,301,281 discloses a semiconductor laser device, such as a Vertical Cavity Surface-Emitting Laser (VCSEL) device which includes a Distributed Bragg Reflector (DBR) made up of layers which are co-doped with different dopants. For instance, a p-type DBR produced by organometallic vapor-phase epitaxy (OMPVE) includes layers having, respectively, a low refractive index and a high refractive index, the layers being made, respectively, of high-Al AlGaAs and low-Al AlGaAs. C, by itself or in addition to Mg, is used as the dopant in the high-Al AlGaAs layers, and Mg is used in the low-Al AlGaAs layers. Because of this co-doping, the semiconductor laser device shall achieve low series resistance and operating voltage, with good manufacturability.

Joyce et al. (1995), "In-situ monitoring of carbon doped GaAs and of periodic carbon doped GaAs/AlAs structures grown by chemical beam epitaxy", Journal of Crystal Growth 146, pp. 394 to 398 discloses that distributed Bragg reflector (DBR) stacks are used in surface emitting laser structures, and that DBR stacks consist of alternate layers of two semiconductor materials with different refractive index such as GaAs and AlAs. Joyce et al. further discloses that DBR structures can be made up of 10-12 structures comprising AlAs and GaAs layers.

Summary of the Invention

It is an object of the invention to provide a laser allowing for a proper reflection performance with simple measures. This object is solved by the subject-matter according to the independent claim.

In accordance with the invention, doped diffraction gratings for use in QCLs and mid-IR wavelength VCSELs can be made by introducing periodic variations in the doping levels that result in periodic refractive index variations. Doping is typically accomplished by use of an n type dopant.

Placement of doped diffraction gratings in the waveguide region of QCLs provides a distributed Bragg reflector (DBR) for stabilizing the emission wavelength. In accordance with the invention, doped diffraction gratings may also be used to provide a DBR for mid-IR wavelength VCSELs. According to an exemplary embodiment, an emission wavelength of a VCSEL may be in the mid infrared range.

Brief Description of the Drawings

FIG. 1 shows the calculated doping dependence of the real index and the loss for InP at a wavelength of 8 $\mu$m.
FIG. 2a shows DBR reflectivity versus doping levels for 20, 40, 60, 80 and 100 mirror pairs in accordance with the invention.
FIG. 2b shows DBR reflectivity versus doping levels for different semiconductor scattering times in accordance with the invention.
FIG. 3a shows a QCL structure in accordance with the invention.
FIG. 3b shows a schematic cross-section
FIG. 3c shows a QCL structure in accordance with the invention.
FIG. 3d shows a VCSEL structure in accordance with the invention.
FIG. 4a shows a method of making a doping grating in accordance with the invention.
FIG. 4b shows a method of making a doping grating in accordance with the invention.
FIGs. 5a-c show a method of making a doping grating in accordance with the invention.

**Detailed Description**

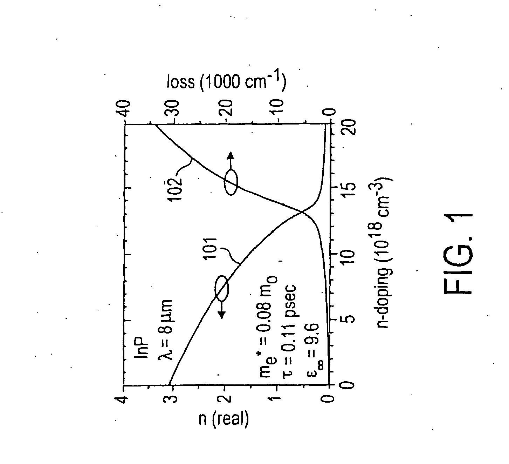

Heavy doping levels on the order of about $10^{18}/cm^3$ are sufficient to produce appreciable refractive index reductions in InP layers. In FIG. 1, plot 101 shows that for a QCL operating at 8 $\mu$m with InP cladding layers, if the doping level is increased from 1-2$\times 10^{17}/cm^3$ to 5$\times 10^{18}/cm^3$ this corresponds to a reduction of real refractive index from about 3.1 to about 2.6. Plot 102 in FIG. 1 shows the increased loss as a function of the doping level.

In accordance with the invention, a periodic variation of the doping can be used to produce a diffraction grating. The typical period for the doping variation, L, is given by L = $\lambda$ / $2n_{eff}$ where $n_{eff}$ is the effective refractive index and $\lambda$ is the wavelength. A typical value for the period for the doping is on the order of 1 $\mu$m. Alternatively, higher order gratings can be defined by using odd multiples of $\lambda/2n_{eff}$, $(2m + 1)\lambda/2n_{eff}$ where m is a positive integer. If this diffraction grating is appropriately positioned in the waveguide region of the QC laser such as, for example, the InP cladding layers or the waveguide core, the diffraction grating can be used as a distributed Bragg reflector (DBR) to control the emission wavelength.

The grating strength may be controlled by the doping concentration and thickness of the heavily doped regions as well as the proximity from the waveguide core. The doping induced reduction in refractive index at the long wavelengths typically associated with QCLs is comparable to or greater than is typically achieved by conventional, shorter wavelength structures that rely on compositional variation to achieve variation of the refractive index. However, the large refractive index step achieved is associated with large absorption losses. Both absorption losses and refractive index steps increase as doping levels are increased. Hence, there is a trade-off between having desirable large refractive index steps and undesirable large absorption losses.

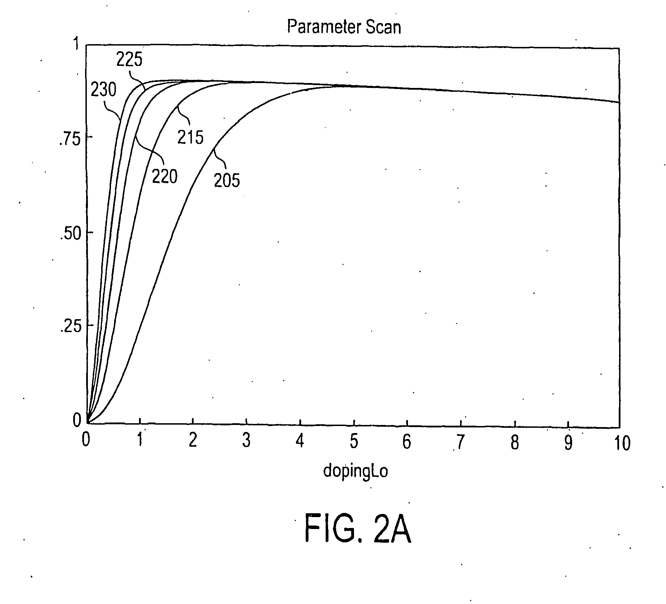

In accordance with the invention, FIG. 2a shows the peak reflectivity, R, for DBRs with differing numbers of mirror pairs as a function of the doping level, Lo, in units of $1\times 10^{18}/cm^3$. Plots 205, 210, 215, 220, 225 and 230 correspond to 20, 40, 60, 80 and 100 mirror pairs, respectively. From FIG. 2a, it is apparent that the reflectivity, R, typically saturates to a peak reflectivity of about 0.9 over a wide range of doping levels, Lo. For example, plot 205 which represents 20 mirror pairs, saturates to a peak reflectivity of about 0.9 at a doping level Lo of about 5 $\times$ $10^{18}$ /$cm^3$ and plot 230 which represents 100 mirror pairs, saturates to a peak reflectivity of about 0.9 at a doping level Lo of about I x $10^{18}$ /$cm^3$. This shows that while higher doping levels, Lo, increase the refractive index step, the absorption loss is increased such that the peak reflectivity is limited. From FIG. 2a, it is apparent that the design details for the DBR are relatively insensitive to the precise doping level and the particular number of mirror pairs selected.

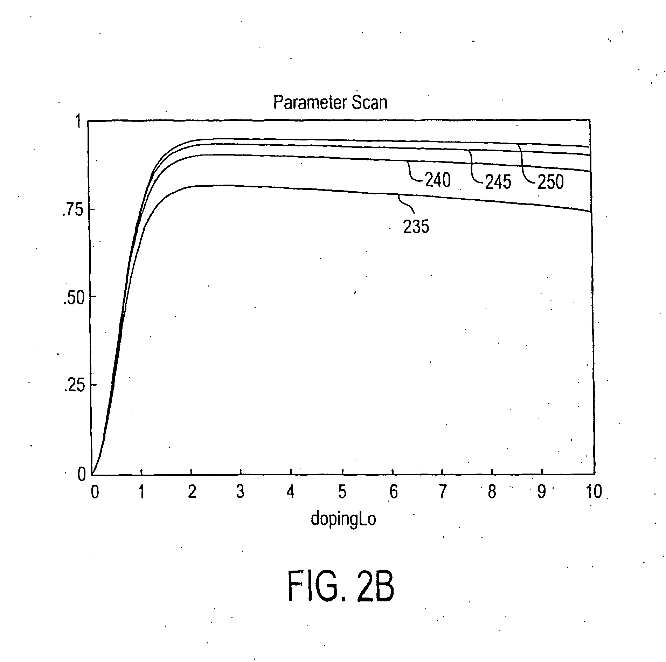

Ultimately, however, the absorption loss limits the quality of the DBR that can be achieved. Plots 205, 210, 215, 220, 225 and 230 shown in FIG. 2a assume a scattering time of 0.1 ps for the semiconductor Drude model used to calculate them. FIG. 2b shows how variation of the scattering time affects DBR reflectivity in accordance with the invention for a DBR having 50 mirror pairs. Plots 235, 240, 245 and 250 correspond to scattering times of 0.05 ps, 0.1 ps, 0.15 ps and 0.2 ps, respectively. Plots 235, 240, 245 and 250 indicate that a larger scattering time typically results in a higher peak reflectivity for the DBR in accordance with the invention. Therefore, using materials having larger scattering times will typically result in better DBRs. For example, for InP materials the scattering time is typically about 0.1 ps at a doping level, Lo, of about 1 x $10^{18}$ /$cm^3$.

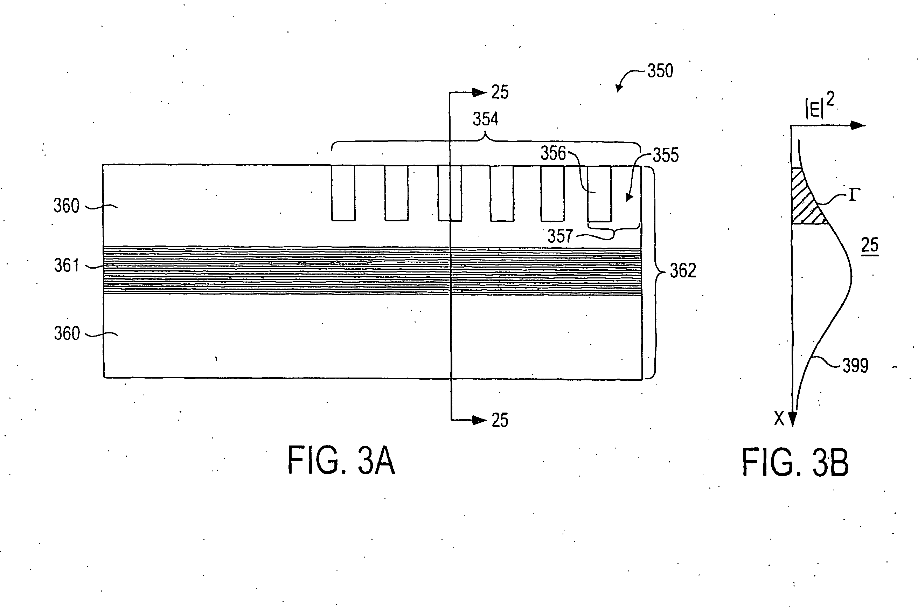

The results shown in FIGs. 2a-b do not take into account the overlap of the DBR region with the waveguide mode. There is typically a 10% to 20 % confinement of the waveguide mode in the upper cladding layer of the waveguide in typical InP QCL 350 (see FIG. 3a). Hence, if the DBR is formed in the entire upper cladding layer, the strength of the DBR may be reduced by an order of magnitude from the results shown in FIGs. 2a-b. The reflectivity R, is defined as:

$$R = \tanh^2 \kappa L \qquad\qquad (1)$$

where $\kappa$, is defined as

$$\kappa = 2\Gamma\Delta n/\lambda \qquad\qquad (2)$$

where $\Delta n$ is the refractive index step between the mirror pairs of the DBR. The overlap $\Gamma$ in Eq. (2), of the cross-section of DBR 354 with waveguide mode cross-section 399 (see FIG. 3b), is given by:

$$\Gamma = \frac{\int\limits_{DBR} |E|^2 \, dA}{\int\limits_{waveguide\ mode} |E|^2 \, dA} \qquad\qquad (4)$$

where the integrals are over the cross-sectional area of the waveguide normal to the propagation direction.

Achieving the reflectivity values, R, shown in FIGs. 2a-b would then require an increase in the mirror pairs of the DBR by an order of magnitude. For example, if the entire upper cladding layer is used to create a DBR having 200 mirror pairs with a doping level, Lo, of 5x $10^{18}$ /cm$^3$, FIGs. 2a-b indicate that a DBR with a reflectivity of about 0.8 to 0.9 may be achieved. A DBR having less overlap with the waveguide mode would require a proportionately longer grating to achieve 0.8 to 0.9 reflectivity.

FIG. 3a shows QCL 350 with waveguide mode 399, an embodiment in accordance with the invention. DBR mirror pair 357 containing DBR elements 356 and 355 forms part of DBR 354 located in cladding region 360. DBR element 356 differs from DBR element 355 in doping level. The difference in doping level between DBR elements. 355 and 356 results in a refractive index difference between DBR element 356 and DBR element 355 at the emission wavelength. DBR 354 functions as the back mirror for QCL 350. Region 361 functions as the waveguide core. Together, cladding region 360 and waveguide core 361. form waveguide layer 362.

FIG. 3b shows the overlap $\Gamma$ as defined in Eq. (4) above between the cross-section of DBR 354 and waveguide mode cross-section 399 in the x-direction.

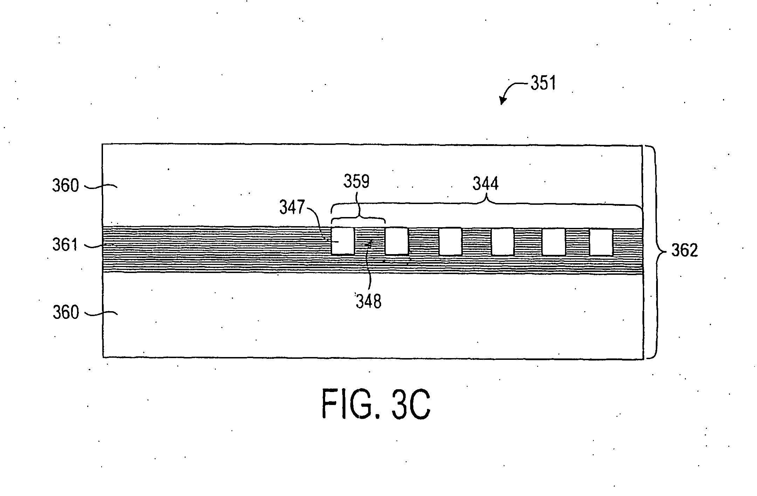

FIG. 3c shows QCL 351 in accordance with the invention. DBR mirror pair 359 containing DBR elements 347 and 348 forms part of DBR 344 located in waveguide core 361. DBR element 347 differs from DBR element 348 in doping level. The difference in doping level between DBR elements 347 and 348 results in a refractive index difference between DBR element 347 and DBR element 348 at the emission wavelength. DBR functions as the back mirror for QCL 351.

In accordance with the invention, doping level variations may be used to create DBRs for vertical cavity surface emitting lasers (VCSELs). Although lasing transitions in QC lasers are typically TM-polarized and not applicable to VCSELs, transverse electric (TE) polarized intersubband transitions exist. For example, TE transitions have been observed in the valence band of Si/SiGe QC lasers where there are two bands, the heavy and light hole bands. Transitions occurring between the heavy and light hole bands of the valence band allow TE-polarized transitions whereas transitions within the same band do not allow TE-polarized transitions.

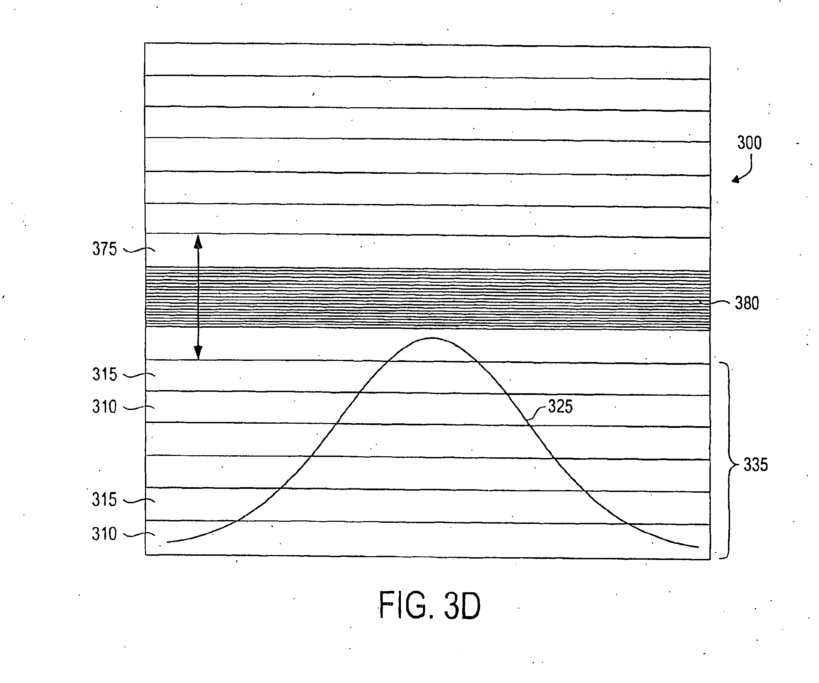

FIG. 3d shows an embodiment in accordance with the invention of epitaxial VCSEL structure 300 with waveguide mode 325. In epitaxial VCSEL structure 300 with laser cavity 375 and active region 380, modulation of the doping levels between about $1\times10^{17}/cm^3$ and $1 \times 10^{18}/cm^3$ in alternating layers 310 and 315, respectively, of DBR 335 allows homogeneous DBR 335 with a high index contrast to be constructed. Each of layers 310 and 315 is typically an odd multiple of a quarter wavelength thick. FIGs. 2a-b show that peak reflectivies of about 0.8 to 0.9 can be achieved for DBR 335 with as few as 20 mirror pairs if doped layers 315 are doped to a level of about $5 \times 10^{18}$ /cm$^3$. Because DBR 335 is not made of different bandgap materials, interfacial potential barriers are absent and series resistance for perpendicular current flow is typically less than a few ohms at a few kA/cm$^2$ current density. As noted above, as the index contrast is increased through increased doping levels, the layer absorption is increased. Thus, the transparency of DBR 335 approaches zero. Therefore, a doped DBR such as DBR 335 is typically used only as the back reflector for VCSEL 300 and not as the output coupler mirror.

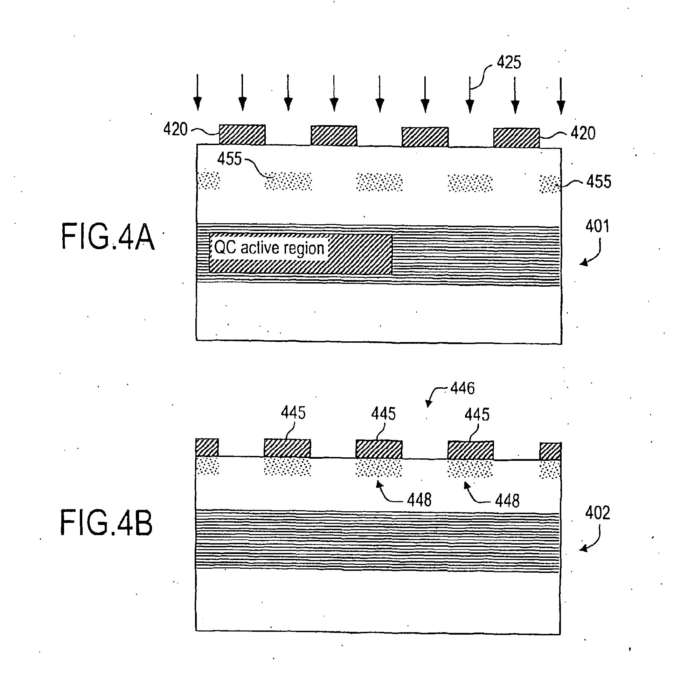

To implement doping-grating structures in the waveguide of a QCL, standard photolithography or e-beam lithography may be used to pattern photoresist on the surface of the semiconductor to form a pattern of lines and spaces having a typical pitch of about 1 $\mu$m or an odd multiple of 1 $\mu$m. In accordance with the invention, FIG. 4a shows patterned photoresist mask 420 used in conjunction with ion implantation of dopant species 425 such as Si or Zn, for example in the fabrication of QCL 401. The doping level and depth of the doping profile are typically controlled by the implant dose and ion implant energy, respectively. Typical dose values are on the order of about 1 x $10^{14}$ /cm$^2$ to about $1\times10^{15}$ /cm$^2$ and typical ion implant energies of about 0.5 MeV to about 2 MeV are used to create highly doped regions 455 in a portion of the waveguide of QCL 40.1 that is patterned into a grating structure. If more implant protection is required than patterned photoresist mask 420 can provide, patterned photoresist mask 420 may be transferred into a hard mask of, for example, metal or dielectric using wet or dry etching techniques or standard lift-off.

In accordance with the invention, FIG. 4b shows a method of creating a doping-grating through solid source diffusion of dopant species 445 into semiconductor wafer 402. The photoresist pattern (not shown) can be transferred onto thin film mask 446, for example, an Si thin film mask, on the semiconductor surface using standard wet or dry etching methods. Semiconductor wafer 402 can then be placed in a diffusion oven having a temperature in the range from about 700 °C to 900 °C where the dopant, for example, Si in the case of an Si thin film mask, will diffuse out of thin film mask 446 into semiconductor wafer 402. FIG. 4b shows diffusion protiles 448 in semiconductor wafer 402 for diffusion times in the range of 1 to 8 hours.

Another example of solid-source diffusion has thin film mask 446 made of, for example, Ge-Au or similar n contact metal onto which the grating pattern has been transferred from the photoresist pattern (not shown) using standard lift-off or wet or dry etching methods. Standard annealing of the Ge-Au n contact metal at about 400 °C to 450 °C for about 10 to 300 seconds in a nitrogen or other inert gas ambient drives the Ge into semiconductor wafer 402 to create diffusion profiles 448.

Vapor diffusion may also be used to create the doping-grating in accordance with the invention and is typically carried out in a closed-quartz tube ampule. In using vapor diffusion, thin film mask 446 is typically made from silicon dioxide and is not the source of the dopant. Thin film mask 446 acts to block the vapor-phase dopant such as Zn, for example, from diffusing into semiconductor wafer 402. Hence, vapor phase diffusion creates a doping profile that is the negative of that shown in FIG. 4b. The vapor phase dopant diffuses into the openings of thin film mask 446 and is blocked from diffusing by thin film mask 446 elsewhere.

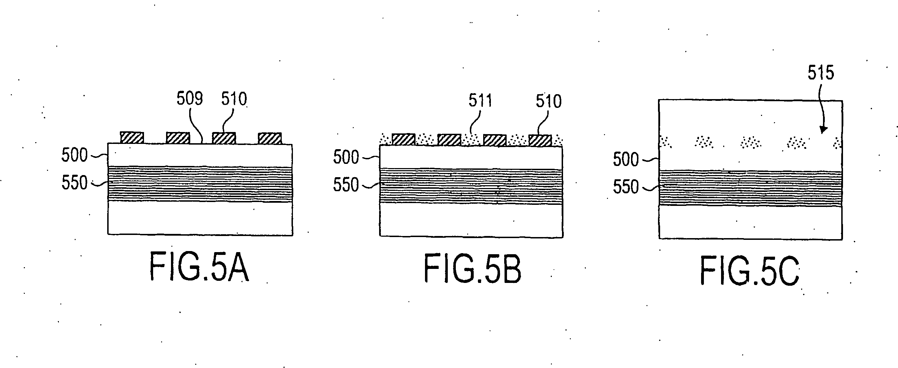

FIGs. 5a-c show the use of selective growth of doped regions to define a doping grating in accordance with the invention. FIG. 5a shows patterned layer 510, typically $SiO_2$ or $Si_3N_x$, that is typically transferred from a patterned photoresist (not shown) through wet or dry etching methods. When high doped layer 511 is regrown over patterned layer 510, typically $SiO_2$ or $Si_3N_x$, high doped layer S11 will grow only on the exposed portions 509 of semiconductor wafer 500 and not on patterned layer 510 resulting in patterned high-doped layer 511. Patterned layer 510, typically $SiO_2$ or $Si_3N_x$, is then removed from semiconductor wafer 500 using wet or dry etching methods and semiconductor wafer 500 can be regrown with low-doped material to bury patterned high doped layer 511 inside low-doped burying layer 515 as shown in FIG. 5c. This allows a buried doping-grating to be created.

Alternatively, high-doped layer 511 can be grown first on semiconductor wafer 500 and patterned layer 510, typically $SiO_2$ or $Si_3N_x$, is deposited over high-doped layer 511. Exposed portions of high-doped layer 511 not protected by patterned layer 510 are then removed by wet or dry etching methods. Patterned layer 510, typically $SiO_2$ or $Si_3N_x$ can then be removed by wet or dry etching methods and semiconductor wafer 500 can be regrown with low -doped burying layer 515. This allows a buried-doping grating to be created. Note that the steps shown in FIGs. 5a-5c may be modified to create a buried-doping grating below waveguide core 550 by using regrowth prior to growth of waveguide core 550.

While the invention has been described in conjunction with specific embodiments, it is evident to those skilled in the art that many alternatives, modifications, and variations will be apparent in light of the foregoing description. Accordingly, the invention is intended to embrace all other such alternatives, modifications, and variations that fall within the scope of the appended claims.

## Claims

1.   A vertical cavity surface emitting laser (300) comprising:

an active region (380); and
a distributed Bragg reflector (335) positioned on one side of said active region (380) to control an emission wavelength, said distributed Bragg reflector (335) comprised of a plurality of mirror pairs (310, 315)

wherein a first member (310) of said mirror pair (310, 315) differs from a second member (315) of said mirror pair (310, 315) by a higher doping level to produce a difference of refractive index so that a modulation of the doping levels in the alternating first and second members (310, 315) allows for a homogenous distributed Bragg reflector (335) with a high refractive index contrast, which distributed Bragg reflector (335) is not made of different bandgap materials.

2.   The laser of claim 1 wherein said higher doping level is equal to or greater than about $1 \times 10^{18}$ /cm$^3$.

3.   The laser of claim 1 or 2 wherein said difference of refractive index at said emission wavelength between said first member (347, 355, 310) and said second member (348, 356, 315) is about 0,5.

4.  The laser of one of the preceding claims wherein said plurality of mirror pairs (359, 356, 310, 315) is in the range from about 20 to about 100.

5.  The laser of one the preceding claims wherein said plurality of mirror pairs (359, 356, 310, 315) is comprised of InP.

6.  The laser of claim 4 or 5 wherein said plurality of mirror pairs (310, 315) is about 20.

## Patentansprüche

1.  Vertical-Cavity Surface-Emitting Laser (300), aufweisend:

    - einen aktiven Bereich (380); und
    - einen verteilten Bragg-Reflektor (335), der auf einer Seite des aktiven Bereichs (380) angeordnet ist, um eine Sendewellenlänge zu steuern, wobei der verteilte Bragg-Reflektor (335) aus einer Mehrzahl von Spiegelpaaren (310, 315) besteht, wobei ein erstes Element (310) des Spiegelpaars (310, 315) sich von einem zweiten Element (315) des Spiegelpaars (310, 315) durch einen höheren Dotierungsgrad unterscheidet, um einen Unterschied im Brechungsindex zu erbringen, so dass eine Modulation des Dotierungsgrads in den alternierenden ersten und zweiten Elementen (310, 315) einen gleichmäßig verteilten Bragg-Reflektor (315) mit einen hohen Brechungsindexkontrast ermöglicht, wobei der verteilte Bragg-Reflektor (335) nicht aus unterschiedlichen Bandabstandsmaterialien hergestellt ist.

2.  Laser gemäß Anspruch 1, wobei der höhere Dotierungsgrad gleich oder größer ist als ungefähr $1 \times 10^{18}/\text{cm}^3$.

3.  Laser gemäß Anspruch 1 oder 2, wobei der Unterschied des Brechungsindex auf der Sendewellenlänge zwischen dem ersten Element (347, 355, 310) und dem zweiten Element (348, 356, 315) ungefähr 0,5 beträgt.

4.  Laser gemäß einem der vorhergehenden Ansprüche, wobei die Mehrzahl von Spiegelpaaren (359, 356, 310, 315) sich in dem Bereich von ungefähr 20 bis ungefähr 100 befindet.

5.  Laser gemäß einem der vorhergehenden Ansprüche, wobei die Mehrzahl von Spiegelpaaren (359, 356, 310, 315) aus InP besteht.

6.  Laser gemäß Anspruch 4 oder 5, wobei die Mehrzahl von Spiegelpaaren (310, 315) ungefähr 20 beträgt.

## Revendications

1.  Laser (300) à cavité verticale émettant en surface comprenant :

    une zone active (380) ; et
    un réflecteur (335) Bragg réparti positionné sur un côté de ladite zone active (380) pour commander une longueur d'ondes d'émission, ledit réflecteur (335) Bragg réparti est constitué d'une pluralité de paires (310, 315) de miroirs dans lesquelles un premier élément (310) de ladite paire (310, 315) de miroirs diffère d'un second élément (315) de ladite paire (310, 315) de miroirs par un niveau de dopage plus élevé pour produire une différence d'indice de réfraction afin qu'une modulation des niveaux de dopage dans les premier et second éléments (310, 315) alternatifs prévoit un réflecteur (335) homogène Bragg réparti avec un contraste élevé d'indice de réfraction, lequel réflecteur (335) Bragg réparti n'est pas fabriqué à partir de différents matériaux à bande interdite.

2.  Laser selon la revendication 1 dans lequel ledit niveau de dopage plus élevé est égal ou supérieur à $1 \times 10^{18}$ /cm$^3$ environ.

3.  Laser selon la revendication 1 ou la revendication 2 dans lequel ladite différence d'indice de réfraction au niveau de ladite longueur d'ondes d'émission entre ledit premier élément (347, 355, 310) et ledit second élément (348, 356, 315) est de 0,5 environ.

4. Laser selon l'une quelconque des revendications précédentes dans lequel ladite pluralité des paires (359, 356, 310, 315) de miroirs est comprise dans la plage d'environ 20 à environ 100.

5. Laser selon l'une quelconque des revendications précédentes dans lequel ladite pluralité des paires (359, 356, 310, 315) de miroirs est constituée d'InP.

6. Laser selon la revendication 4 ou la revendication 5 dans lequel ladite pluralité des paires (310, 315) de miroirs est de 20 environ.

FIG. 1

Parameter Scan

205
215
220
225
230

dopingLo

FIG. 2A

FIG. 2B

EP 1 705 763 B1

350

25

354

356 355

360

361

357

360

362

25

FIG. 3A

|E|$^2$

Γ

25

399

X

FIG. 3B

351

360

361

360

347

359

344

348

362

FIG. 3C

FIG. 3D

EP 1 705 763 B1

FIG.4A

425

420

420

455

455

401

QC active region

FIG.4B

446

445

445

445

448

448

402

FIG.5C

FIG.5B

FIG.5A

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6301281 B

**Non-patent literature cited in the description**

- **JOYCE et al.** In-situ monitoring of carbon doped GaAs and of periodic carbon doped GaAs/AlAs structures grown by chemical beam epitaxy. *Journal of Crystal Growth,* 1995, vol. 146, 394-398